Europäisches Patentamt

European Patent Office

Office européen des brevets

(19)

(11) **EP 0 931 241 B1**

(12) **EUROPÄISCHE PATENTSCHRIFT**

(45) Veröffentlichungstag und Bekanntmachung des Hinweises auf die Patenterteilung:
**13.08.2003   Patentblatt 2003/33**

(21) Anmeldenummer: **98936250.4**

(22) Anmeldetag: **25.06.1998**

(51) Int Cl.$^7$: **G01B 21/04**, B25J 9/16

(86) Internationale Anmeldenummer:
**PCT/DE98/01744**

(87) Internationale Veröffentlichungsnummer:
**WO 99/008070 (18.02.1999 Gazette 1999/07)**

(54) **VERFAHREN ZUR KORREKTUR DER MESSFEHLER EINER KOORDINATEN-MESSMASCHINE**

METHOD FOR CORRECTING MEASUREMENT ERRORS IN A MACHINE MEASURING CO-ORDINATES

PROCEDE DE CORRECTION DES ERREURS DE MESURE D'UNE MACHINE DE MESURE PAR COORDONNEES

(84) Benannte Vertragsstaaten:
**DE FR GB IT NL SE**

(30) Priorität: **11.08.1997  DE 19734695**

(43) Veröffentlichungstag der Anmeldung:
**28.07.1999   Patentblatt 1999/30**

(73) Patentinhaber: **Leica Microsystems Wetzlar GmbH**
**35578 Wetzlar (DE)**

(72) Erfinder: **RINN, Klaus**
**D-35452 Heuchelheim (DE)**

(74) Vertreter: **Stamer, Harald**
**Leica Microsystems International Holdings GmbH,**
**Konzernstelle Patente + Marken,**
**Postfach 20 20**
**35530 Wetzlar (DE)**

(56) Entgegenhaltungen:
**EP-A- 0 751 369**       **DE-A- 4 006 835**
**GB-A- 2 197 478**       **US-A- 4 583 298**

**Beschreibung**

Die Erfindung betrifft ein Verfahren zur Bestimmung einer Korrekturfunktion zur Beseitigung der koordinaten-abhängigen Meßfehler einer Koordinaten-Meßmaschine durch Selbstkalibrierung.

Hochgenaue Koordinaten-Meßmaschinen werden in der Halbleiterindustrie zur Vermessung der Strukturen auf Masken oder Wafern eingesetzt. Die genaue Kenntnis der Koordinaten der Strukturen auf Masken ist zwingend erforderlich, um eine kontrollierte Fertigung von integrierten Schaltkreisen durchführen zu können.

Die Meßwerte dieser hochgenauen Koordinaten-Meßmaschinen besitzen Fehlerkomponenten, welche vom Meßort, also der gemessenen Koordinate selbst, abhängen. Dabei existieren systematische Fehlerkomponenten, die aus der Konstruktion und der Auswahl der Bauelemente der Koordinaten-Meßmaschine selbst resultieren. So sind z. B. bekannte Fehlerursachen Mängel in der Spiegelorthogonalität und der Spiegelebenheit, Verzeichnungen in der Skalierung der Meßachsen (sogenannter Kosinusfehler) sowie die Durchbiegung der zum Korrigieren benutzten Maske.

Zum Erreichen höchster Genauigkeit der Messungen benötigen hochgenaue Koordinaten-Meßmaschinen eine koordinaten-abhängige Fehlerkorrektur. Die Ermittlung dieser Korrektur wird im allgemeinen durch Vergleichen mit einem Standard erreicht. Bei extrem hohen Genauigkeiten, wie sie beispielsweise in der Meßtechnik von Halbleitersubstraten benötigt werden, existiert jedoch kein hinreichend genauer Standard. Dafür ist es bekannt, eine Koordinaten-Meßmaschine mit sich selbst zu kalibrieren, indem ein und dasselbe Objekt in mehreren Drehlagen vermessen wird. Mit einer durch Selbstkalibrierung erzeugten Fehlerkorrekturfunktion werden alle Fehler der Koordinaten-Meßmaschine mit Ausnahme des Skalierungsfehlers erfaßt. Dieser kann nur durch Vergleich mit einem geeichten Längenstandard bestimmt werden.

<u>**Stand der Technik**</u>

Die US 4 583 298 beschreibt die Selbstkalibrierung einer Koordinaten-Meßmaschine mit Hilfe einer sogenannten Kalibrierplatte, auf welcher ein Gitter angeordnet ist. Die Positionen der Gitterpunkte sind jedoch nicht kalibriert. Die Gitterplatte wird auf den Objekttisch der Koordinaten-Meßmaschine aufgelegt, und die Positionen ihrer Gitterpunkte werden gemessen. Dieselbe Gitterplatte wird dann zwei- oder mehrmals um jeweils 90° um eine Drehachse weitergedreht und in jeder der eingestellten Orientierungen werden die Positionen der Gitterpunkte gemessen. Die Meßergebnisse werden mathematisch zurückgedreht und verschiedene Korrekturfaktoren und Tabellen so optimiert, daß die zurückgedrehten Datensätze eine bessere Übereinstimmung aufweisen.

Die US 4,583,298 befaßt sich ausführlich mit dem Problem fehlerhafter oder auch unzuverlässiger Korrekturen. Als Ursache werden Fehler bei der Messung der zur Korrekturbestimmung herangezogenen Meßwerte ermittelt. Es wird gezeigt, daß eine mathematisch eindeutige Korrektur nur dann erzielt wird, wenn mehr als zwei verschiedene Drehlagen mit derselben Gitterplatte vermessen werden und dabei die Drehzentren für die Drehungen zwischen den Drehlagen ausreichend verschieden sind. Dazu wird die Gitterplatte wie bekannt auf den Objekttisch aufgelegt und die Positionen ihrer Gitterpunkte in mehreren Orientierungen der Gitterplatte vermessen. Die Orientierungen werden beispielsweise durch mehrfache Drehungen um 90° um ihren Mittelpunkt erreicht. Danach jedoch muß die Gitterplatte auf eine gänzlich andere Position auf dem Objekttisch verschoben werden. Dort wird die Messung der Positionen ihrer Gitterpunkte in mehreren Orientierungen, wie bereits vorbekannt, wiederholt. Wesentlich ist hierbei, daß dieselbe Gitterplatte auf dem Objekttisch verschoben werden muß.

Diese Forderung erweist sich in der Praxis jedoch als nachteilig; denn am einfachsten dreht man die Gitterplatte um solche Winkel, bei denen die äußeren Dimensionen ineinander übergehen. Dabei ist der Drehpunkt stets der Mittelpunkt der Gitterplatte. So wird in der US 4,583,298 beispielsweise eine quadratische Kalibrierplatte in einen quadratischen Rahmen eingelegt und nach jeder Messung um 90° versetzt wieder in ihm abgelegt. Damit sind alle Drehzentren gleich dem Mittelpunkt der Kalibrierplatte. Nur wenn die Drehzentren weit auseinander liegen, d.h. ihre Abstände ähnlich groß sind wie die Abstände der Kalibrierstrukturen, ist die Fehlerkorrektur besser. Aber selbst bei Realisierung deutlich unterschiedlicher Drehzentren sind die ermittelten Korrekturfaktoren sowie das Ergebnis der Korrektur nie ganz zufriedenstellend.

Um eine signifikante Verschiebung der Drehzentren zu erlauben, muß der Halterungsmechanismus, wie z. B. der quadratische Rahmen, verschoben werden. Dabei muß auch der Meßbereich im Vergleich zum unverschobenen Objekt vergrößert werden. Die zu diesem Umbau der Koordinaten-Meßmaschine erforderlichen Maßnahmen sind mit erheblichen Nachteilen verbunden. So ist die Anbringung eines verschiebbaren Halterahmens für die Kalibrierplatte auf dem Objekttisch problematisch. Sind nämlich andere Maskenhalterungen auf dem Probentisch vorhanden (z.B. Vakuum-Chuck oder spezielle Mehr-Punkt-Lagerung), müßten diese extra für die Kalibriermessungen abgebaut werden. Das Auflegen eines Halterahmens auf vorhandene Maskenhalterungen kommt ebenfalls nicht in Frage, da diese beschädigt werden können bzw. keine ebene Auflagefläche für den Halterahmen bieten.

Auch die Vergrößerung des Meßbereichs zur Vermessung der Kalibrierplatte im verschobenen Zustand ist problematisch. Sie erfordert kostenintensive konstruktive Änderungen, die in die Fertigungskosten der Maschine eingehen. Auch werden die Außenabmessungen der Maschine vergrößert. Die Aufstellfläche der Maschine wirkt sich aber direkt auf ihre Betriebskosten aus, weil in der Halbleiterindustrie die Aufstellfläche im Reinraum sehr kostenintensiv ist.

## Aufgabe

Der Erfindung liegt daher die Aufgabe zugrunde, ein Verfahren zur Bestimmung einer Korrekturfunktion zur Beseitigung der koordinatenabhängigen Meßfehler einer Koordinaten-Meßmaschine anzugeben, in welchem bei den Kalibriermessungen unter Verwendung der bereits vorhandenen, unverschiebbaren Maskenhalterungen Drehungen des jeweiligen Kalibriersubstrates um ein einziges Drehzentrum ausreichend sind, ohne das Kalibriersubstrat auch noch verschieben zu müssen. Dennoch soll eine optimale Fehlerkorrektur erzielt werden. Es soll eine kontinuierliche Korrekturfunktion angegeben werden, mit der eine Korrektur beliebiger Meßorte im gesamten Meßbereich, also auch zwischen den Punkten eines Kalibriergitters, möglich ist.

Diese Aufgabe wird bei einem Verfahren der eingangs genannten Art erfindungsgemäß durch den unabhängigen Patentanspruch 1 gelöst. Vorteilhafte Ausgestaltungen und Weiterbildungen der Erfindung sind Gegenstand der obhörgigen Ansprüche.

## Beschreibung

Mathematisch betrachtet ist eine vom Meßort abhängige Korrekturfunktion zur Beseitigung der koordinaten-abhängiger Meßfehler einer Koordinaten-Meßmaschine eine zwei- oder dreidimensionale Funktion $\vec{K}(\vec{r})$. Die Korrekturfunktion ist in der Praxis immer stetig und differenzierbar. Durch Anwendung dieser Korrekturfunktion $\vec{K}(\vec{r})$ auf eine gemessene fehlerbehaftete Rohkoordinate $\vec{r}$ (gemeint ist der Ortsvektor) einer Struktur eines beliebigen Meßobjekts erhält man die zugehörige korrigierte Koordinate $\vec{r}_{korr} = \vec{r} + \vec{K}(\vec{r})$.

Zur Bestimmung der Korrekturfunktion $\vec{K}(\vec{r})$ wird diese durch eine Reihenentwicklung eines Satzes vorgegebener Fitfunktionen $\vec{k}_i(\vec{r})$ approximiert. Es gilt also:

$$\vec{K}(\vec{r}) \approx \sum_{i=0}^{N} a_i \cdot \vec{k}_i(\vec{r}),$$

wobei $a_i$ =Fitparameter und N=Anzahl der vorgegebenen Fitfunktionen $\vec{k}_i(\vec{r})$ sind.

Zur Bestimmung der Korrekturfunktion $\vec{K}(\vec{r})$ müssen daher die Fitparameter $a_i$ zu den Fitfunktionen $\vec{k}_i(\vec{r})$ so bestimmt werden, daß die Korrektur optimal, also der Restfehler minimal oder gleich Null wird.

Die Erfindung geht von der Erkenntnis aus, daß es spezielle Komponenten der Korrekturfunktion $\vec{K}(\vec{r})$ gibt, welche nicht eindeutig bestimmt oder mit sehr großem Fehler behaftet sind. Hierbei handelt es sich vorwiegend um Komponenten, die bei den Kalibriermessungen aller Orientierungen eines zur Kalibrierung benutzten Referenzobjektes stets in sich selbst übergehen (exakt oder auch nur näherungsweise), d.h. die drehsymmetrischen Komponenten sind invariant für die durchgeführten Drehungen des Referenzobjekts. Es handelt sich dabei jeweils um eine Linearkombination $\vec{S}(\vec{r})$ von Fitfunktionen $\vec{k}_i(\vec{r})$, die als Ganzes drehsymmetrisch bezüglich aller durchgeführten Drehungen $D_k$ ist. Es gilt dann die Symmetriebedingung $\vec{S}(\vec{r}) = D_k \vec{S}(\vec{r})$. Als Spezialfall der Linearkombination könnte es sich um eine einzige identifizierbare Fitfunktion $\vec{k}_i(\vec{r})$ handeln.

Diese drehsymmetrischen Komponenten in Form der Linearkombination $\vec{S}(\vec{r})$ liefern keinen oder einen sehr ungenauen Beitrag zur Approximation der idealen, also exakt richtigen Korrekturfunktion $\vec{K}(\vec{r})$. So kann das Vorhandensein solcher drehsymmetrischer Komponenten dazu führen, daß die Fitparameter $a_i$ zu den Fitfunktionen $\vec{k}_i(\vec{r})$ nicht eindeutig bestimmt werden können. Zur Verbesserung der Fehlerkorrektur werden sie daher erfindungsgemäß aus der Reihenentwicklung der Korrekturfunktion $\vec{K}(\vec{r})$ entfernt oder meßtechnisch ausgeschlossen.

Die Erfindung gibt damit ein Verfahren zur Fehlerkorrektur einer Koordinaten-Meßmaschine an, welches die drehsymmetrischen Fehlerkomponenten gezielt unberücksichtigt läßt. Es werden drei verschiedene Ausführungsbeispiele A, B und C angegeben.

A: Eine erste, meßtechnische Lösung besteht in einem Verfahren, bei welchem durch Messung mit zwei unterschiedlich dimensionierten Referenzobjekten keine drehsymmetrischen Anteile in der Korrekturfunktion entstehen.

B: Eine zweite Lösung besteht in einem Verfahren, bei dem durch Messung an einem einzigen Referenzobjekt die drehsymmetrischen Linearkombinationen $\vec{S}(\vec{r})$ der Fitfunktionen $\vec{k}_i(\vec{r})$ bestimmt und aus dem Satz der Fitfunktionen entfernt werden. Mit dem verkürzten Satz der Fitfunktionen wird dann die Korrekturfunktion approximiert.

C: Die drehsymmetrischen Linearkombinationen $\vec{S}(\vec{r})$ stören zwar bei der. Bestimmung der Fitparameter $a_i$, sind aber zur Beschreibung bestimmter Fehleranteile erwünscht und daher ursprünglich in dem allgemeinen Satz der Fitfunktionen enthalten Es wird daher als dritte Lösung ein Verfahren zur Ermittlung einer Korrekturfunktion $\vec{K}(\vec{r})$ angegeben, mit welchem durch Messung mit zwei unterschiedlich dimensionierten Referenzobjekten die ermittelten drehsymmetrischen Fehlerkomponenten bei der Approximation der Korrekturfunktion zunächst eliminiert werden und danach in die approximierte Korrekturfunktion wieder eingeführt werden.

Die Korrekturfunktion $\vec{K}(\vec{r})$ wird optimiert, indem jeweils eines der Referenzobjekte den Meßbereich der Koordinaten-Meßmaschine ganz abdeckt.

Die Erfindung wird im folgenden anhand von Ausführungsbeispielen mit Hilfe der schematischen Zeichnungen näher erläutert. Es zeigen:

Fig. 1a :     ein erstes Referenzobjekt in einer Anfangsorientierung k = 0;

Fig. 1b :     ein erstes Referenzobjekt in einer ersten Kalibrierorientierung k = 1.

Fig. 1c :     ein erstes Referenzobjekt in einer zweiten Kalibrierorientierung k = 2.

Fig. 2a :     ein zweites Referenzobjekt in einer Anfangsorientierung k = 0;

Fig. 2b :     ein zweites Referenzobjekt in einer ersten Kalibrierorientierung k = 1.

Fig. 2c :     ein zweites Referenzobjekt in einer zweiten Kalibrierorientierung k = 2.

A: Beschreibung eines meßtechnischen Verfahrens zur Realisierung eines Ausführungsbeispiels, wie es in Anspruch 2 angegeben ist.

Fig. 1a zeigt ein starres, unkalibriertes Referenzobjekt 1, das zur Durchführung einer Selbstkalibrierung in der Anfangsorientierung k = 0 auf einen Objekttisch 3 einer Koordinaten-Meßmaschine aufgelegt ist. Die aktuelle Orientierung des Referenzobjekts 1 wird durch eine Markierung 4 angezeigt. Sie erscheint in der Anfangsorientierung in der rechten unteren Ecke des Referenzobjekts 1. Das Referenzobjekt 1 ist so groß gewählt, daß es den gesamten Meßbereich der Koordinaten-Meßmaschine und dementsprechend fast den ganzen Objekttisch 3 abdeckt.

Zur Aufnahme des Referenzobjekts 1 dient eine übliche, zur Vereinfachung hier nicht dargestellte Maskenhalterung, die für die Messung quadratischer Masken ausgelegt ist. So ist es bekannt, die Maske zwangskräftefrei auf drei Auflagepunkten zu lagern. Die durch das Eigengewicht erzeugte Durchbiegung wird berechnet und aus den gemessenen Koordinaten der Strukturen der Maske herausgerechnet. Andere Maskenhalterungen saugen die Maske mit Vakuumfüßen an. Dies erzeugt jedoch nicht exakt beschreibbare Durchbiegungen der Maske. Im betrachteten Beispiel wird das Referenzobjekt 1 (wie auch später andere Referenzobjekte) stets bündig an die untere Kante des Objekttisches 3 angelegt, die auch für die zu vermessenden Masken als Anlage dient und zu der verschiebbare Auflagepunkte für unterschiedliche Maskengrößen vorhanden sind.

Auf dem Referenzobjekt 1 wird eine Anzahl j von Referenzstrukturen 5 ausgewählt, deren Koordinaten zur Durchführung der Selbstkalibrierung gemessen werden sollen. Zunächst wird das Referenzobjekt 1 in der Anfangsorientierung auf die Maskenhalterung aufgelegt. In dieser Anfangsorientierung k = 0 des ersten Referenzobjekts 1 werden die Anfangskoordinaten (des Ortsvektors) $\vec{r}_{1j0}$ der j ausgewählten Referenzstrukturen 5 gemessen.

Danach müssen die Referenzstrukturen 5 des Referenzobjektes 1 noch in mindestens einer anderen Orientierung des Referenzobjekts 1 gemessen werden. Diese sogenannte Kalibrierorientierung muß von der Anfangsorientierung verschieden sein und durch Drehung um eine Drehachse 6 aus der Anfangsorientierung hervorgegangen sein. Wenn, wie in diesem Beispiel, ein quadratisches Referenzobjekt 1 gewählt und dieses stets bündig an die untere Kante des Objekttisches 3 angelegt wird, bietet sich aufgrund der vorhandenen Maskenhalterung eine Drehachse 6 senkrecht durch Mitte des Referenzobjekts 1 an.

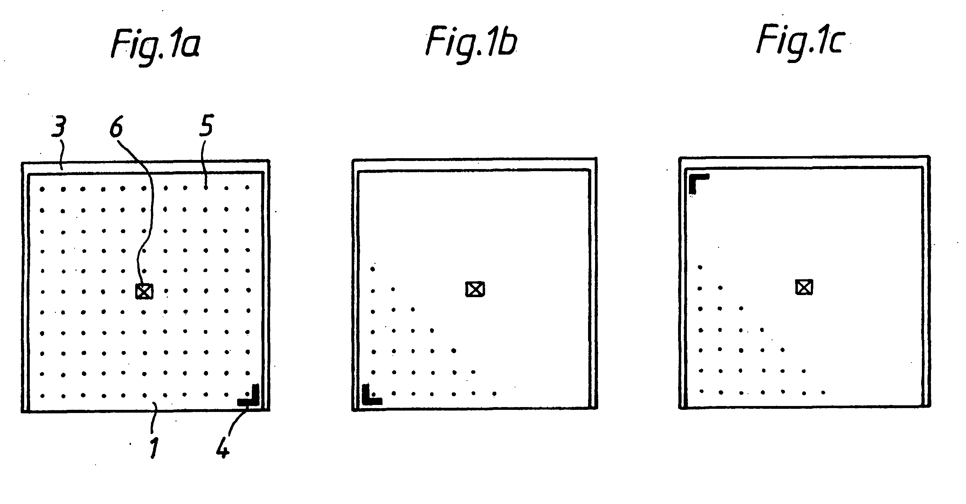

Fig. 1b zeigt das Referenzobjekt 1 in der ersten Kalibrierorientierung k = 1. Sie wird aus der Anfangsorientierung durch eine 90-Grad-Drehung um die Drehachse 6 durch die Mitte des Referenzobjekts 1 erzeugt. Die Markierung 4 erscheint in der ersten Kalibrierorientierung in der linken unteren Ecke des Referenzobjekts 1. In dieser ersten Kalibrierorientierung k = 1 werden die Kalibrierkoordinaten $\vec{r}_{1j1}$ der j Referenzstrukturen 5 des ersten Referenzobjektes 1 gemessen.

Nach der Messung in der Anfangsorientierung und einer Kalibrierorientierung kann bereits eine vollständige Korrekturfunktion $\vec{K}(\vec{r}_{jk})$ berechnet werden. Zur Erstellung einer optimierten Korrekturfunktion $\vec{K}(\vec{r}_{jk})$ kann mit Vorteil die Messung von Kalibrierkoordinaten der Referenzstrukturen 5 in mindestens einer weiteren, von den bisher verwendeten Orientierungen des Referenzobjekts 1 verschiedenen Kalibrierorientierung erfolgen, wie nachfolgend beschrieben wird.

Fig. 1c zeigt das Referenzobjekt 1 in der zweiten Kalibrierorientierung k = 2 . Sie wird aus der Anfangsorientierung durch eine 180-Grad-Drehung um die Drehachse 6 durch die Mitte des Referenzobjekts 1 erzeugt. Die Markierung 4 erscheint in der zweiten Kalibrierorientierung in der linken oberen Ecke des Referenzobjekts 1. In dieser zweiten Kalibrierorientierung k = 2 werden die Kalibrierkoordinaten $\vec{r}_{1j2}$ der j Referenzstrukturen 5 gemessen.

Es wurden bisher also an dem Referenzobjekt 1 zu den Referenzstrukturen 5 in der Anfangsorientierung k = 0 die Anfangskoordinaten $\vec{r}_{1j0}$, in der Kalibrierorientierung k = 1 die Kalibrierkoordinaten $\vec{r}_{1j1}$ und in der Kalibrierorientierung k = 2 die Kalibrierkoordinaten $\vec{r}_{1j2}$ gemessen. Jetzt sind Messungen der Koordinaten der Referenzstrukturen 5 an einem zweiten Referenzobjekt 2 erforderlich. Auch dieses muß in von einander verschiedenen Orientierungen, die durch Drehung um eine gemeinsame Drehachse erzeugt werden, vermessen werden. Dazu wird das Referenzobjekt 1 vom Objekttisch 3 der Koordinatenmeßmaschine entfernt und statt dessen ein Referenzobjekt 2 aufgelegt.

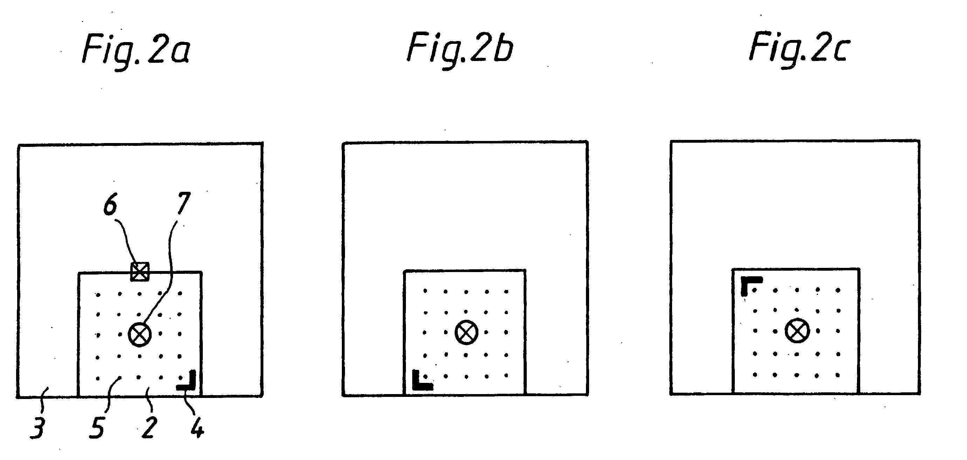

**Figur 2a** zeigt das zweite Referenzobjekt 2 auf dem Objekttisch 3. Das zweite Referenzobjekt 2 ist deutlich erkennbar kleiner ausgewählt als das vorher vermessene erste Referenzobjekt 1. Dargestellt sind die Markierung 4 zur Kennung der Orientierung, die Referenzstrukturen 5 des zweiten Referenzobjektes 2 sowie die Mitte des zweiten Referenzobjekts 2, durch welche die Drehachse 7 zur Einstellung der verschiedenen Orientierungen hindurchgeht. Man erkennt, daß durch die unterschiedlichen Größen der beiden Referenzobjekte 1, 2 die beiden Drehachsen 6, 7 einen deutlichen Abstand von einander besitzen.

**Figur 2a** zeigt nun das zweite Referenzobjekt 2 in seiner Anfangsorientierung k = 0. In dieser werden die Anfangskoordinaten $\vec{r}_{2j0}$ der Referenzstrukturen 5 gemessen.

**Figur 2b** zeigt das zweite Referenzobjekt 2 in der ersten Kalibrierorientierung k = 1. Sie wird durch eine 90-Grad-Drehung des Referenzobjekts 2 aus seiner Anfangsorientierung k = 0 erzeugt. In dieser ersten Kalibrierorientierung k = 1 werden zu den Referenzstrukturen 5 des zweiten Referenzobjekts 2 die Kalibrierkoordinaten $\vec{r}_{2j1}$ gemessen.

Durch eine 180-Grad-Drehung aus der Anfangsorientierung um die Drehachse 7 wird das zweite Referenzobjekt 2 in die zweite Kalibrierorientierung k = 2 gebracht, wie dies in **Figur 2c** dargestellt ist. In dieser Kalibrierorientierung k = 2 werden zu den Referenzstrukturen 5 die Kalibrierkoordinaten $\vec{r}_{2j2}$ gemessen.

Damit sind zu den Referenzstrukturen 5 des zweiten Referenzobjekts 2 ebenfalls die Anfangs- und Kalibrierkoordinaten in drei verschiedenen Orientierungen gemessen worden, wie dies bereits für das erste Referenzobjekt 1 durchgeführt wurde.

Zur Approximation der Korrekturfunktion $\vec{K}(\vec{r}_{jk})$ durch

$$\vec{K}(\vec{r}_{jk}) \approx \sum_{i=0}^{N} a_i \vec{k}_i(\vec{r}_{jk})$$

müssen zunächst die Fitfunktionen $\vec{k}_i(\vec{r}_{jk})$ angegeben werden. Aus der mathematischen Literatur sind viele vollständige Sätze linear unabhängiger Funktionen bekannt, welche eine Korrekturfunktion $\vec{K}(\vec{r}_{jk})$ beliebig genau approximieren können. Die bekanntesten sind beispielsweise Polynom- und Fourierreihen. Es sind auch bestimmte linear unabhängige Funktionen bekannt, die sich zur Korrektur bestimmter Fehler besonders eignen. Es wird nun hieraus ein Satz von Fitfunktionen $\vec{k}_i(\vec{r}_{jk})$ vorgegeben, welcher die Korrekturfunktion $\vec{K}(\vec{r}_{jk})$ hinreichend genau beschreibt.

Die Anfangskoordinaten $\vec{r}_{1j0}$ und die Kalibrierkoordinaten $\vec{r}_{1j1}$ und $\vec{r}_{1j2}$ des ersten Referenzobjekts 1 sowie die Anfangskoordinaten $\vec{r}_{2j0}$ und die Kalibrierkoordinaten $\vec{r}_{2j1}$ und $\vec{r}_{2j2}$ des zweiten Referenzobjekts 2 werden nun mit der Korrekturfunktion $\vec{K}(\vec{r}_{jk})$ beaufschlagt, welche durch eine Approximation mit den vorgegebenen linear unabhängigen Funktionen beschrieben werden soll. Zunächst sind die Fitparameter $a_i$ der N vorgegebenen linear unabhängigen Fitfunktionen $\vec{k}_i$ ($\vec{r}_{jk}$) noch unbekannt. Sie sollen nun bestimmt werden.

Dazu werden die mit der Korrekturfunktion $\vec{K}$ ($\vec{r}_{jk}$) beaufschlagten Kalibrierkoordinaten mittels Drehfunktionen $D_k$, die ihre Drehung in die ihnen zugeordnete Anfangsorientierung beschreiben, in die ihnen jeweils zugeordnete Anfangsorientierung zurückgedreht, d.h., daß die Kalibrierkoordinaten $\vec{r}_{1j1}$ und $\vec{r}_{1j2}$ des ersten Referenzobjektes 1 in die Anfangsorientierung des ersten Referenzobjektes 1 zurückgedreht werden, während andererseits die Kalibrierkoordinaten $\vec{r}_{2j1}$ und $\vec{r}_{2j2}$ des zweiten Referenzobjektes 2 in die Anfangsorientierung des zweiten Referenzobjektes 2 zurückgedreht werden.

Unter Berücksichtigung aller Referenzstrukturen 5 auf den beiden Referenzobjekten 1, 2 werden nun die Fitparameter $a_i$ so berechnet, daß die jeweils zu einer bestimmten Referenzstruktur 5 zugehörigen korrigierten Anfangskoordinaten und die dazugehörigen korrigierten und zurückgedrehten Kalibrierkoordinaten eine möglichst gute Übereinstimmung aufweisen.

Damit wird eine Approximation der Korrekturfunktion $\vec{K}(\vec{r}_{jk})$ erzeugt, die sowohl für die durchgeführten Drehungen auf dem ersten Referenzobjekt 1 als auch für die durchgeführten Drehungen auf dem zweiten Referenzobjekt 2 optimiert ist. Indem die beiden Referenzobjekte 1, 2 für sich jeweils um eine konstante Drehachse, aber untereinander um verschiedene Drehachsen gedreht wurden, besitzt die ermittelte Korrekturfunktion keine Komponenten, die bezüglich aller benutzten Drehungen drehsymmetrisch wären. Durch das beschriebene Verfahren der Selbstkalibrierung kann die Korrekturfunktion $\vec{K}(\vec{r}_{jk})$ keine drehsymmetrische Anteile enthalten, da es keine Fitfunktionen gibt, die bei Drehungen um beide Achsen drehsymmetrisch sein könnten.

B: Beschreibung eines Verfahrens zur Realisierung eines Ausführungsbeispiels, wie es in Anspruch 3 angegeben ist.

Bei diesem Verfahren werden zu den Referenzstrukturen 5 eines Referenzobjektes 1, wie es in den Figuren 1a, 1b, 1c dargestellt ist, in einer Anfangsorientierung k = 0 die Anfangskoordinaten $\vec{r}_{1j0}$, in einer ersten Kalibrierorientierung k = 1 die Kalibrierkoordinaten $\vec{r}_{1j1}$ und in einer zweiten Kalibrierorientierung k = 2 die Kalibrierkoordinaten $\vec{r}_{1j2}$ gemessen. Eine Messung mit einem weiteren Referenzobjekt ist nicht erforderlich.

Nun werden zu den vorgegebenen Fitfunktionen $\vec{k}_i(\vec{r}_{jk})$ alle Linearkombinationen $\vec{S}(\vec{r})$ bestehend aus einer beliebigen Anzahl P der Fitfunktionen $\vec{k}_i(\vec{r}_{jk})$ ge-

sucht, die bezüglich der beiden durchgeführten Drehungen wieder ineinander übergehen. Jede dieser drehsymmetrischen Linearkombinationen kann beschrieben werden durch

$$\bar{S}(\vec{r}) = \sum_{i=0}^{P} s_i \cdot \vec{k}_i(\vec{r}_{jk}).$$

Dabei sind die $s_i$ die

Fitparameter dieser Linearkombination. Es werden nur jene Linearkombinationen $\vec{S}(\vec{r})$ gesucht, die für alle durchgeführten Drehungen $D_k$ die Symmetriebedingung $\vec{S}(\vec{r}) = D_k \cdot \vec{S}(\vec{r})$ erfüllen.

Für jede gefundene drehsymmetrische Linearkombination $\vec{S}(\vec{r})$ muß der gewählte Satz der linear unabhängigen Fitfunktionen $\vec{k}_i(\vec{r}_{jk})$ überarbeitet werden. Dazu wird ein neuer Satz linear unabhängiger Fitfunktionen $\vec{k}_i^{(1)}(\vec{r}_{jk})$ erzeugt, wobei diese neuen Fitfunktionen $\vec{k}^{(1)}(\vec{r}_{jk})$ jeweils Linearkombinationen der bisherigen $\vec{k}_i(\vec{r}_{jk})$ sind und zunächst noch den gleichen Funktionenraum aufspannen. Dabei muß eine der neuen linear unabhängigen Fitfunktionen $\vec{k}_i^{(1)}(\vec{r}_{jk})$ die vorher gefundene drehsymmetrische Linearkombination $\vec{S}(\vec{r})$ sein, und zwar sei dies die N-te. Dann gilt: $\vec{S}(\vec{r}) = \vec{k}_N^{(1)}(\vec{r}_{jk})$.

Dann wird diese drehsymmetrische Linearkombination $\vec{k}_N^{(1)}(\vec{r}_{jk})$, also die N-te aus dem neuen Satz der Fitfunktionen $\vec{k}_i^{(1)}(\vec{r}_{jk})$ gestrichen. Damit beträgt die Anzahl der neuen Fitfunktionen $\vec{k}_i^{(1)}(\vec{r}_{jk})$ nur noch N-1. Damit spannt der neue Satz der Fitfunktionen $\vec{k}_i^{(1)}(\vec{r}_{jk})$ nicht mehr denselben Funktionenraum auf wie der ursprüngliche Satz der Fitfunktionen $\vec{k}_i(\vec{r}_{jk})$. Die Dimension des durch die neuen Fitfunktionen $\vec{k}_i^{(1)}(\vec{r}_{jk})$ aufgespannten Funktionenraums hat sich damit um 1 verringert.

Für jede gefundene drehsymmetrische Linearkombination $\vec{S}(\vec{r})$ wird eine solche Anpassung des Satzes der Fitfunktionen $\vec{k}_i^{(1)}(\vec{r}_{jk})$ vorgenommen, bis es keine Linearkombination $\vec{S}(\vec{r})$ mehr gibt, die die oben genannte Symmetriebedingung für alle Drehfunktionen $D_k$ erfüllt. Erst mit dem letzten erzeugten Satz der Fitfunktionen $\vec{k}_i^{(M)}(\vec{r}_{jk})$ nach M-facher Wiederholung der beschriebenen Anpassung des Satzes der Fitfunktionen kann dann in bekannter Weise eine Korrekturfunktion $\vec{K}(\vec{r}_{jk})$ berechnet werden.

Das heißt, die gemessenen Anfangskoordinaten $\vec{r}_{1j0}$ und Kalibrierkoordinaten $\vec{r}_{1j1}$, $\vec{r}_{1j2}$ werden mathematisch mit der zu bestimmenden Korrekturfunktion $\vec{K}(\vec{r}_{jk})$ beaufschlagt. Danach werden die korrigierten Kalibrierkoordinaten $\vec{r}_{1j1}$, $\vec{r}_{1j2}$ mathematisch in die Anfangsorientierung k = 0 zurückgedreht. Dann ist es möglich, die Fitparameter $a_i$ zu der gesuchten Korrekturfunktion $\vec{K}(\vec{r}_{jk})$ die mit dem letzten erzeugten Satz der Fitfunktionen $\vec{k}_i^{(M)}(\vec{r}_{jk})$ approximiert werden soll, zu bestimmen. Dazu werden die Fitparameter $a_i$ wieder so optimiert, daß die korrigierten und zurückgedrehten Kalibrierkoordinaten und die korrigierten Anfangskoordinaten eine größtmögliche Übereinstimmung aufweisen.

Die so erzeugte Korrekturfunktion $\vec{K}(\vec{r}_{jk})$ ist damit von allen unbestimmten Linearkombinationen $\vec{S}(\vec{r})$ ihrer Fitfunktionen bereinigt. Dabei wurde jedoch eine Verringerung der Dimension des aufgespannten Funktionenraums in Kauf genommen. Bei geeigneter Wahl der ursprünglichen Fitfunktionen $\vec{k}_i(\vec{r}_{jk})$ kann es nun passiert sein, daß bestimmte Fitfunktionen $\vec{k}_i(\vec{r}_{jk})$, die ganz bestimmten Fehlern zugeordnet werden können, aus dem Satz der bei der Erzeugung der Korrekturfunktion berücksichtigten Fitfunktionen $\vec{k}_i^{(M)}(\vec{r}_{jk})$ herausgefallen sind. Zwar wurden diese Fitfunktionen mit den drehsymmetrischen Linearkombinationen aus dem Satz der Fitfunktionen entfernt, weil sie bei der Approximation der Korrekturfunktion $\vec{K}(\vec{r}_{jk})$ gestört haben, aber zur Korrektur der bestimmten, ihnen zugeordneten Fehler sollten sie eigentlich bevorzugt in der Korrekturfunktion $\vec{K}(\vec{r}_{jk})$ erhalten bleiben. Nachfolgend wird ein weiteres Verfahren beschrieben, welches dieser Forderung Rechnung trägt.

C: Beschreibung eines Verfahrens zur Realisierung eines Ausführungsbeispiels, wie es im Anspruch 4 angegeben ist.

Durch Vermessung der Anfangs- und Kalibrierkoordinaten der Referenzstrukturen 5 auf einem ersten Referenzobjekt 1 in einer Anfangsorientierung und mindestens zwei Kalibrierorientierungen, wie sie in den Figuren 1a, 1b, 1c dargestellt sind, wird mit den im Anspruch 3 angegebenen und im vorangegangenen Beschreibungsteil B beschriebenen Verfahrensschritten eine Korrekturfunktion $\vec{K}_1(\vec{r}_{jk})$ bestimmt und durch einen modifizierten Satz von Fitfunktionen $\vec{K}_i^{(M)}(\vec{r}_{jk})$ approximiert. Aus diesem modifizierten Satz der Fitfunktionen $\vec{k}_i^{(M)}(\vec{r}_{jk})$ sind alle bezüglich der Drehungen um die erste Drehachse 6 drehsymmetrischen Linearkombinationen $\vec{S}(\vec{r})$ entfernt. Für jede gestrichene drehsymmetrische Linearkombination $\vec{S}(\vec{r})$ wird die Dimension des von den Fitfunktionen aufgespannten Funktionenraums um 1 verringert.

Wie bereits erläutert, werden die drehsymmetrischen Linearkombinationen $\vec{S}(\vec{r})$ aus der ursprünglichen Basis der Fitfunktionen $\vec{k}_i(\vec{r}_{jk})$ entfernt, weil man mit den drehsymmetrischen Linearkombinationen $\vec{S}(\vec{r})$ als Basisfunktion die Fitparameter $a_i$ nicht bestimmen kann. Bei gezielter Wahl der ursprünglichen Fitfunktionenbasis enthalten jedoch die drehsymmetrischen Linearkombinationen $\vec{S}(\vec{r})$ Komponenten, die zur Beschreibung bestimmter Fehler gezielt eingesetzt werden sollten und daher in der Korrekturfunktion erwünscht sind. Nachdem nun die Fitparameter $a_i$ der ersten Korrekturfunktion $\vec{K}_1(\vec{r}_{jk})$ im Bezug auf die Drehungen des ersten Referenzobjekts 1 bestimmt wurden, ist man bemüht, die gestrichenen Komponenten der ursprünglichen Funktionenbasis, also die drehsymmetrischen Linearkombinationen $\vec{S}(\vec{r})$, wieder in die Korrekturfunktion hineinzubekommen.

Dazu wird nun auf einem zweiten Referenzobjekt 2 mit einer zweiten Drehachse 7 eine zweite Korrekturfunktion $\vec{K}_2(\vec{r}_{jk})$ bestimmt. Dazu werden die Koordinaten der Referenzstrukturen 5 des zweiten Referenzobjekts 2 in der Anfangsorientierung k = 0 und mindestens zwei weiteren verschiedenen Kalibrierorientierungen k = 1 und k = 2 , wie sie in den Figuren 2a, 2b, 2c dargestellt sind, gemessen. Diese Kalibrierorientierungen sind durch Drehungen mit den Drehfunktionen $D_{2k}$ aus der Anfangsorientierung hervorgegangen. Die so gemessenen Anfangskoordinaten $\vec{r}_{2j0}$ und Kalibrierkoordinaten $\vec{r}_{2j1}$, $\vec{r}_{2j2}$ werden alle mit der bereits bestimmten ersten Korrekturfunktion $\vec{K}_1(\vec{r}_{jk})$ korrigiert.

Zu diesen korrigierten Meßwerten des zweiten Referenzobjekts 2 und den mit diesem zweiten Referenzobjekt 2 ausgeführten Drehungen $D_{2k}$ wird mit den Verfahrensschritten des Anspruchs 3 eine zweite Korrekturfunktion $\vec{K}_2(\vec{r}_{jk})$ bestimmt. Sie soll ebenfalls mit der für die erste Korrekturfunktion $\vec{K}_1(\vec{r}_{jk})$ ursprünglich vorgegebenen Fitfunktionenbasis $\vec{k}_i(\vec{r}_{ik})$ approximiert werden. Dazu werden alle zu den am zweiten Referenzobjekt 2 um die zweite Drehachse 7 durchgeführten Drehungen $D_{2k}$ drehsymmetrischen Linearkombinationen $\vec{S}(\vec{r})$ bestimmt. Für jede solche gefundene drehsymmetrische Linearkombination $\vec{S}(\vec{r})$ wird dann diese ursprünglich vorgegebene Fitfunktionenbasis $\vec{k}_i(\vec{r}_{jk})$ in eine neue aus Linearfunktionen dieser Fitfunktionen $\vec{k}_i(\vec{r}_{jk})$ umgebaut und die Linearkombination $\vec{S}(\vec{r})$ daraus gestrichen. Auch hierbei verringert sich die Dimension des von der Fitfunktionenbasis aufgespannten Funktionenraums mit jeder gestrichenen Linearkombination $\vec{S}(\vec{r})$ um 1.

Wenn alle bezüglich der Drehungen des zweiten Referenzobjekts 2 symmetrischen Linearkombinationen $\vec{S}(\vec{r})$ entfernt sind, wird in bekannter Weise eine zweite Korrekturfunktion $\vec{K}_2(\vec{r}_{jk})$ bestimmt. Diese enthält nun keine drehsymmetrischen Linearkombinationen $\vec{S}(\vec{r})$ bezüglich aller Drehungen $D_{2k}$ um die zweite Drehachse 7, die beim zweiten Referenzobjekt 2 benutzt wurden. Jedoch enthält sie drehsymmetrische Linearkombinationen bezüglich der ersten Drehachse 6, die bei den Drehungen $D_{1k}$ des ersten Referenzobjekts 1 benutzt wurden.

Ebenso enthält die zuerst bestimmte Korrekturfunktion $\vec{K}_1(\vec{r}_{jk})$ keine drehsymmetrischen Linearkombinationen bezüglich der ersten Drehachse 6, die bei der Drehung des ersten Referenzobjekts 1 benutzt wurde. Allerdings enthält sie drehsymmetrische Linearkombinationen $\vec{S}(\vec{r})$ bezüglich der Drehungen um die zweite Drehachse 7, die bei den Messungen mit dem zweiten Referenzobjekt 2 benutzt wurden.

Es ist nun das Ziel eine Gesamt-Korrekturfunktion anzugeben, in der die drehsymmetrischen Linearkombinationen $\vec{S}(\vec{r})$ bezüglich der an beiden Referenzobjekten 1, 2 verwendeten Drehungen $D_{1k}$ und $D_{2k}$ um beide Drehachsen enthalten sind. Erst dann werden die Fehler korrigiert, denen die in den fehlenden drehsymmetrischen Linearkombinationen enthaltenen Fitfunktionen zugeordnet sind. Dazu wird durch Addition der ersten Korrekturfunktion $\vec{K}_1(\vec{r}_{jk})$ mit der zweiten Korrekturfunktion $\vec{K}_2(\vec{r}_{jk})$ eine Gesamt-Korrekturfunktion

$$\vec{K}_{Ges}(\vec{r}_{jk}) = \vec{K}_1(\vec{r}_{jk}) + \vec{S}_2(\vec{r}_{jk})$$

erzeugt. In dieser Gesamt-Korrekturfunktion $\vec{K}_{Ges}(\vec{r}_{jk})$ sind also alle zur Bestimmung der Fitfunktionen entfernten drehsymmetrischen Linearkombinationen $\vec{S}(\vec{r})$ wieder enthalten, und es wird durch die Fitfunktionen wieder der volle Funktionenraum aufgespannt.

### Bezugszeichenliste

1 erstes Referenzobjekt
2 zweites Referenzobjekt
3 Objekttisch der Koordinatenmeßmaschine
4 Markierung
5 Referenzstrukturen
6 Drehachse des ersten Referenzobjekts 1
7 Drehachse des zweiten Referenzobjekts 2

### Patentansprüche

1. Verfahren zur Bestimmung einer Korrekturfunktion $\vec{K}(\vec{r}_{jk})$ zur Beseitigung der koordinaten-abhängigen Meßfehler einer Koordinaten-Meßmaschine durch Selbstkalibrierung, bei dem schrittweise

    a) zu einer Anzahl j von Referenzstrukturen (5) auf einem starren, unkalibrierten Referenzobjekt (1) in einer Anfangsorientierung k = 0 des Referenzobjekts (1) die Anfangskoordinaten $\vec{r}_{j0}$ und in einer Anzahl k $\geq$1 unterschiedlicher, durch Drehung aus der Anfangsorientierung erzeugter Kalibrierorientierungen die Kalibrierkoordinaten $\vec{r}_{jk}$ gemessen werden, wobei die Kalibrierorientierungen durch Drehungen mit Drehfunktionen $D_k$ um eine einzige Drehachse (6) des Referenzobjekts (1) erzeugt werden,

    b) die Anfangskoordinaten $\vec{r}_{j0}$ und die Kalibrierkoordinaten $\vec{r}_{jk}$ mit einer koordinaten-abhängigen Korrekturfunktion $\vec{K}(\vec{r}_{jk})$ beaufschlagt werden, welche durch eine Approximation

$$\vec{K}(\vec{r}_{jk}) \approx \sum_{i=0}^{N} a_i \vec{k}_i(\vec{r}_{jk})$$

    mit zunächst unbekannten Fitparametern $a_i$ und einer Anzahl N von vorgegebenen, linear

unabhängigen Fitfunktionen $\vec{k}_i(\vec{r}_{jk})$ beschrieben wird,

c) die mit der Korrekturfunktion $\vec{K}(\vec{r}_{jk})$ beaufschlagten Kalibrierkoordinaten $(\vec{r}_{jk} + \vec{K}(\vec{r}_{jk}))$ mittels Drehfunktionen $D_k$ in die Anfangsorientierung zurückgedreht werden,

d) die Fitparameter $a_i$ so berechnet werden, daß zu jeweils einer Referenzstruktur (5) alle korrigierten und zurückgedrehten Kalibrierkoordinaten $D_k(\vec{r}_{jk} + \vec{K}(\vec{r}_{jk}))$ sowie die korrigierten Anfangskoordinaten $(\vec{r}_{j0} + \vec{K}(\vec{r}_{j0}))$ eine möglichst gute Übereinstimmung aufweisen, und

e) eine kontinuierliche, auf beliebige zu messende Koordinaten anzuwendende Korrekturfunktion $\vec{K}(\vec{r}_{jk})$ erzeugt wird, wobei aus deren Fitfunktionen $\vec{k}_i(\vec{r}_{jk})$ oder einer Auswahl davon keine Linearkombinationen gebildet werden können, die für alle durchgeführten Drehungen $D_k$ in sich selbst übergehen.

2. Verfahren nach Anspruch 1, mit dem zusätzlichen Schritten,

a) daß auf einem ersten Referenzobjekt (1) mit einer ersten, festen Drehachse (6) die Anfangskoordinaten $\vec{r}_{1j0}$ und die Kalibrierkoordinaten $\vec{r}_{1jk}$ gemessen werden,

b) daß auf einem zweiten Referenzobjekt (2) mit einer zweiten, festen Drehachse (7) die Anfangskoordinaten $\vec{r}_{2j0}$ und die Kalibrierkoordinaten $\vec{r}2_{jk}$ gemessen werden,

c) daß alle gemessenen Anfangs- und Kalibrierkoordinaten mit derselben Korrekturfunktion $\vec{K}(\vec{r}_{jk})$ beaufschlagt werden,

d) daß die mit der Korrekturfunktion $\vec{K}(\vec{r}_{jk})$ beaufschlagten Kalibrierkoordinaten $(\vec{r}_{1jk} + \vec{K}(\vec{r}_{jk}))$ und $(\vec{r}_{2jk} + \vec{K}(\vec{r}_{jk}))$ für jedes Referenzobjekt (1, 2) separat unter Anwendung der Drehfunktionen $D_k$ in ihre jeweilige Ausgangsorientierung zurückgedreht werden,

e) und daß die Fitparameter $a_i$ so berechnet werden, daß auf jedem Referenzobjekt (1) und (2) separat alle zurückgedrehten und korrigierten Kalibrierkoordinaten und Anfangskoordinaten zu jeder Referenzstruktur (5) eine möglichst gute Übereinstimmung aufweisen.

3. Verfahren nach Anspruch 1, mit den zusätzlichen Schritten,

a) daß zu den vorgegebenen Fitfunktionen $\vec{k}_i$

$(\vec{r}_{jk})$ alle drehsymmetrischen Linearkombinationer

$$\vec{S}(\vec{r}) = \sum_{i=0}^{P} s_i \cdot \vec{k}_i\left(\vec{r}_{jk}\right)$$

einer beliebigen Anzahl P < N der Fitfunktionen $\vec{k}_i(\vec{r}_{jk})$ mit den Fitparametern $s_i$ bestimmt werden, die für die Drehfunktionen $D_k$ die Symmetriebedingung $\vec{S}(\vec{r}) = D_k\vec{S}(\vec{r})$ erfüllen,

b) daß bei Existenz einer solchen drehsymmetrischen Linearkombination $\vec{S}(\vec{r})$ der bisherige Satz von linear unabhängigen Fitfunktionen $\vec{k}_i$ $(\vec{r}_{ij})$ durch einen neuen Satz linear unabhängiger Fitfunktionen $\vec{k}_i^{(1)}(\vec{r}_{jk})$ ersetzt wird, wobei diese neuen Fitfunktionen $\vec{k}_i^{(1)}(\vec{r}_{jk})$ jeweils Linearkombinationen der bisherigen $\vec{k}_i(\vec{r}_{jk})$ sind und den gleichen Funktionenraum aufspannen und wobei eine der neuen Fitfunktionen, nämlich $\vec{k}_N^{(1)}(\vec{r})$, die drehsymmetrische Linearkombination $\vec{S}(\vec{r})$ ist,

c) daß die drehsymmetrische Linearkombination $\vec{S}(\vec{r}) = \vec{k}_N^{(1)}(\vec{r}_{jk})$ aus dem Satz der Fitfunktionen $\vec{k}_i^{(1)}(\vec{r}_{jk})$ gestrichen wird, so daß deren Anzahl nur noch N -1 beträgt,

d) daß die genannten Verfahrensschritte a), b), c) wiederholt werden, bis es keine Linearkombination $\vec{S}(\vec{r})$ mehr gibt, die die Symmetriebedingung $\vec{S}(\vec{r}) = D_k \cdot \vec{S}(\vec{r})$ für die Drehfunktionen $D_k$ erfüllt,

e) und daß mit dem nach M-fachem Wiederholen der oben beschriebenen Verfahrensschritte a), b), c) erzeugten Satz der Fitfunktionen . $\vec{k}_i^{(M)}(\vec{r}_{jk})$ die Korrekturfunktion $\vec{K}(\vec{r}_{jk})$ berechnet wird.

4. Verfahren nach Anspruch 3, mit dienes zusätzlichen Schritten

a) daß mit einem ersten Referenzobjekt (1) und Drehungen $D_{1k}$ um eine erste, feste Drehachse (6) eine erste Korrekturfunktion $\vec{K}_1(\vec{r}_{jk})$ bestimmt wird, welche bezüglich aller Drehungen $D_{1k}$ um die erste Drehachse (6) keine drehsymmetrischen Linearkombinationen $\vec{s}(\vec{r})$ mehr enthält, dafür jedoch drehsymmetrische Linearkombinationen $\vec{S}(\vec{r})$ bezüglich anderer, nicht benutzter Drehachsen enthält,

b) daß mit einem zweiten Referenzobjekt (2) und Drehungen mit Drehfunktionen $D_{2k}$ um eine zweite, feste von der ersten verschiedenen Drehachse (7) weitere Kalibriermessungen durchgeführt werden, dabei alle gemessenen Anfangskoordinaten $\vec{r}_{2j0}$ und Kalibrierkoordinaten $\vec{r}_{2jk}$ des zweiten Referenzobjekts (2) mit der bereits berechneten ersten Korrekturfunktion $\vec{K}_1(\vec{r}_{jk})$ korrigiert werden, die mit der ersten Korrekturfunktion $\vec{K}_1(\vec{r}_{jk})$ korrigierten Kalibrierkoordinaten dann mit einer zweiten, noch zu bestimmenden Korrekturfunktion $\vec{K}_2(\vec{r}_{jk})$ beaufschlagt und mit den Drehfunktionen $D_{2k}$ in ihre Anfangsorientierung zurückgedreht werden, und daß hieraus eine zweite Korrekturfunktion $\vec{K}_2(\vec{r}_{jk})$ bestimmt wird, welche keine drehsymmetrischen Linearkombinationen $\vec{S}(\vec{r})$ bezüglich aller Drehungen $D_{2k}$ um die zweite Drehachse (7) mehr enthält, dafür jedoch drehsymmetrische Linearkombinationen $\vec{S}(\vec{r})$ bezüglich aller Drehungen $D_{1k}$ um die erste Drehachse (6) enthält,

c) und daß durch Addition der ersten Korrekturfunktion $\vec{K}_1(\vec{r}_{jk})$ mit der zweiten Korrekturfunktion $\vec{K}_2(\vec{r}_{jk})$ eine Gesamt-Korrekturfunktion

$$\vec{K}_{Ges}(\vec{r}_{jk}) = \vec{K}_1(\vec{r}_{jk}) + \vec{K}_2(\vec{r}_{jk})$$

berechnet wird, in der drehsymmetrische Linearkombinationen $\vec{S}(\vec{r})$ bezüglich der verwendeten Drehungen $D_{1k}$ und $D_{2k}$ um beide Drehachsen enthalten sind.

5. Verfahren nach Anspruch 4, bei dem zur schrittweisen Verfeinerung der Korrekturfunktion $\vec{K}_{Ges}(\vec{r}_{jk})$ der Schritt b) des Anspruchs 2 mit weiteren Referenzobjekten und diesen zugeordneten weiteren, vorher nicht benutzten Drehachsen wiederholt wird und die ermitteiten Korrekturfunktionen immer weiter aufaddiert werden.

6. Verfahren nach Anspruch 2, 4 oder 5, bei dem eines der Referenzobjekte den gesamten Meßbereich der Koordinaten-Meßmaschine abdeckt.

7. Verfahren nach einem der vorangegangenen Ansprüche, bei dem das Referenzobjekt quadratisch ist und die Drehachse durch seine Mitte verläuft.

## Claims

1. Method for determining a correction function $\bar{K}(\bar{r}_{jk})$ for rectifying the coordinate-dependent measuring errors of a coordinate-measuring machine by means of self-calibration, in which, in a stepwise fashion,

   a) in relation to a number j of reference structures (5) on a rigid, uncalibrated reference object (1) the initial coordinates $\bar{r}_{j0}$ are measured in an initial orientation k = = 0 of the reference object (1), and in a number k ≥ 1 of different calibration orientations produced by rotation from the initial orientation the calibration coordinates $\bar{r}_{jk}$ are measured, the calibration orientations being produced by rotations with the aid of rotation functions $D_k$ about a single rotation axis (6) of the reference object (1),

   b) the initial coordinates $\bar{r}_{j0}$ and the calibration coordinates $\bar{r}_{jk}$ are operated upon by a coordinate-dependent correction function $\bar{K}(\bar{r}_{jk})$ which is described by an approximation

$$\bar{K}(\bar{r}_{jk}) \approx \sum_{i=0}^{N} a_i \bar{k}_i(\bar{r}_{jk})$$

   with initially unknown fit parameters $a_i$ and a number N of prescribed, linearly independent fit functions $\bar{k}_i(\bar{r}_{jk})$,

   c) the calibration coordinates $(\bar{r}_{jk} + \bar{K}(\bar{r}_{jk}))$ operated upon by the correction function $\bar{K}(\bar{r}_{jk})$ are rotated back into the initial orientation by means of rotation functions $D_k$,

   d) the fit parameters $a_i$ are calculated such that in relation to a reference structure (5) in each case all the corrected and rotated-back calibration coordinates $D_k(\bar{r}_{jk} + \bar{K}(\bar{r}_{jk}))$ and the corrected initial coordinates $(\bar{r}_{j0} + \bar{K}(\bar{r}_{j0}))$ agree as well as possible, and

   e) a continuous correction function $\bar{K}(\bar{r}_{jk})$ to be applied to arbitrary coordinates to be measured is generated, it being impossible to form from the fit functions $\bar{k}_i(\bar{r}_{jk})$ or a selection therefrom linear combinations which go over into themselves for all the rotations $D_k$ carried out.

2. Method according to Claim 1, having the additional steps:

   a) that the initial coordinates $\bar{r}_{1j0}$ and the calibration coordinates $\bar{r}_{1jk}$ are measured on a first reference object (1) with a first, fixed rotation axis (6),

   b) that the initial coordinates $\bar{r}_{2j0}$ and the calibration coordinates $\bar{r}_{2jk}$ are measured on a second reference object (2) with a second, fixed rotation axis (7),

   c) that all the measured initial and calibration coordinates are operated upon by the same correction function $\bar{K}(\bar{r}_{jk})$,

d) that the calibration coordinates $(\bar{r}_{1jk} + \bar{K}(\bar{r}_{jk}))$ and $(\bar{r}_{2jk} + \bar{K}(\bar{r}_{jk}))$ operated upon by the correction function $\bar{K}(\bar{r}_{jk})$ are rotated back into their respective initial orientation for each reference object (1, 2) separately using the rotation functions $D_k$,

e) and that the fit parameters $a_i$ are calculated such that on each reference object (1) and (2) all the rotated-back and corrected calibration coordinates and initial coordinates separately agree as well as possible in relation to each reference structure (5).

3. Method according to Claim 1, having the additional steps:

a) that in relation to the prescribed fit functions $\bar{k}_i(\bar{r}_{jk})$ a determination is made of all the rotationally symmetrical linear combinations

$$\overline{S}(\overline{r}) = \sum_{i=0}^{P} s_i \cdot \overline{k}_i(\overline{r}_{jk})$$

of an arbitrary number P < N of the fit functions $\bar{k}_i(\bar{r}_{jk})$ with the fit parameters $s_i$ which fulfil the symmetry condition $\bar{S}(\bar{r}) = D_k\bar{S}(\bar{r})$ for the rotation functions $D_k$,

b) that given the existence of such a rotationally symmetrical linear combination $\bar{S}(\bar{r})$ the previous set of linearly independent fit functions $\bar{k}_i(\bar{r}_{jk})$ is replaced by a new set of linearly independent fit functions $\bar{k}^{(1)}_i(\bar{r}_{jk})$, these new fit functions $\bar{k}^{(1)}_i(\bar{r}_{jk})$ in each case being linear combinations of the previous $\bar{k}_i(\bar{r}_{jk})$ and defining the same function space, and one of the new fit functions, specifically $\bar{k}^{(1)}_N(\bar{r})$, being the rotationally symmetrical linear combination $\bar{S}(\bar{r})$,

c) that the rotationally symmetrical linear combination $\bar{S}(\bar{r}) = \bar{k}_N^{(1)}(\bar{r}_{jk})$ is deleted from the set of fit functions $\bar{k}^{(1)}_i(\bar{r}_{jk})$ so that their number is only N-1,

d) that the said method steps a), b), c), are repeated until there is no longer any linear combination $\bar{S}(\bar{r})$ which fulfils the symmetry condition $\bar{S}(\bar{r}) = D_k \cdot \bar{S}(\bar{r})$ for the rotation function $D_k$,

e) and that correction function $\bar{K}(\bar{r}_{jk})$ is calculated by means of the set of fit functions $\bar{k}_i^{(M)}$

$(\bar{r}_{jk})$ generated after the M-fold repetition of the above described method steps a), b), c).

4. Method according to Claim 3, having the additional steps:

a) that using a first reference object (1) and rotations $D_{1k}$ about a first, fixed rotation axis (6) a first correction function $\bar{K}_1(\bar{r}_{jk})$ is determined which no longer includes any rotationally symmetrical linear combinations $\bar{S}(\bar{r})$ relative to all the rotations $D_{1k}$ about the first rotation axis (6), but in return includes rotationally symmetrical linear combinations $\bar{S}(\bar{r})$ relative to other, unused rotation axes,

b) that further calibration measurements are carried out using a second reference object (2) and rotations with rotation functions $D_{2k}$ about a second, fixed rotation axis (7), differing from the first, in which case all the measured initial coordinates $\bar{r}_{2j0}$ and calibration coordinates $\bar{r}_{2jk}$ of the second reference object (2) are corrected by means of the already calculated first correction function $\bar{K}_1(\bar{r}_{jk})$, the calibration coordinates corrected by means of the first correction function $\bar{K}_1(\bar{r}_{jk})$ are then operated upon by a second correction function $\bar{K}_2(\bar{r}_{jk})$, still to be determined, and are rotated back into their initial orientation by means of the rotation functions $D_{2k}$, and in that herefrom a second correction function $\bar{K}_2(\bar{r}_{jk})$ is determined, which no longer includes any rotationally symmetrical linear combinations $\bar{S}(\bar{r})$ relative to all the rotations $D_{2k}$ about the second rotation axis (7), but in return includes rotationally symmetrical linear combinations $\bar{S}(\bar{r})$ relative to all the rotations $D_{1k}$ about the first rotation axis (6),

c) and that by adding the first correction function $\bar{K}_1(\bar{r}_{jk})$ to the second correction function $\bar{K}_2$ $(\bar{r}_{jk})$ a total correction function

$$\bar{K}_{Ges}(\bar{r}_{jk}) = \bar{K}_1(\bar{r}_{jk}) + \bar{K}_2(\bar{r}_{jk})$$

is calculated which includes rotationally symmetrical linear combinations $\bar{s}(\bar{r})$ relative to the rotations $D_{1k}$ and $D_{2k}$ used about the two rotation axes.

5. Method according to Claim 4, in which for the purpose of stepwise refinement of the correction function $\bar{K}_{Ges}(\bar{r}_{jk})$, step b) of Claim 2 is repeated with further reference objects and further, previously unused rotation axes assigned thereto, and the correction functions determined are repeatedly added up.

**6.** Method according to Claim 2, 4 or 5, in which one of the reference objects covers the entire measuring range of the coordinate-measuring machine.

**7.** Method according to one of the preceding claims, in which the reference object is square and the rotation axis runs through its centre.

**Revendications**

**1.** Procédé pour la détermination d'une fonction de correction $\vec{K}(\vec{r}_{jk})$ pour l'élimination, par auto-calibrage, des erreurs de mesure dépendant des coordonnées d'une machine de mesure des coordonnées, lequel comprend les étapes suivantes :

a) pour un nombre j de structures de référence (5) sur un objet de référence (1) fixe non calibré, dans une orientation initiale k = 0 de l'objet de référence (1), on mesure les coordonnées initiales $\vec{r}_{j0}$ et les coordonnées de calibrage $\vec{r}_{jk}$ selon un nombre k ≥1 d'orientations de calibrage différentes obtenues par rotation à partir de l'orientation initiale, les orientations de calibrage étant obtenues par rotation au moyen de fonctions de rotation $D_k$ autour d'un axe de rotation unique (6) de l'objet de référence (1),
b) on injecte les coordonnées initiales $\vec{r}_{j0}$ et les coordonnées de calibrage $\vec{r}_{jk}$ dans une fonction de correction $\vec{K}(\vec{r}_{jk})$ dépendant des coordonnées, décrite par une approximation

$$\vec{K}(\vec{r}_{jk}) \approx \sum_{i=0}^{N} a_i \vec{k}_i(\vec{r}_{jk})$$

avec des paramètres d'ajustement $a_i$ inconnus au départ et un nombre N défini de fonctions d'ajustement $\vec{k}_i(\vec{r}_{jk})$ linéaires indépendantes,
c) on ramène les coordonnées de calibrage $(\vec{r}_{jk} + \vec{K}(\vec{r}_{ik}))$, injectées dans la fonction de correction $\vec{K}(\vec{r}_{jk})$, à leur orientation initiale au moyen des fonctions de rotation $D_k$,
d) on calcule les paramètres d'ajustement $a_i$ de telle sorte que pour chaque structure de référence (5), toutes les coordonnées de calibrage $D_k(\vec{r}_{jk} + \vec{K}(\vec{r}_{jk}))$ ramenées en arrière et corrigées correspondent le mieux possible aux coordonnées initiales corrigées $(\vec{r}_{j0} + \vec{K}(\vec{r}_{j0}))$ et
e) on génère une fonction de correction $\vec{K}(\vec{r}_{jk})$ continue applicable à n'importe quelles coordonnées à mesurer, aucune combinaison linéaire s'identifiant à elle-même pour toutes les rotations $D_k$ réalisées ne pouvant être formée à partir de ses fonctions d'ajustement $\vec{k}_i(\vec{r}_{jk})$ ou d'une sélection d'entre elles.

**2.** Procédé selon la revendication 1, avec les étapes supplémentaires suivantes :

a) on mesure les coordonnées initiales $\vec{r}_{1j0}$ et les coordonnées de calibrage $\vec{r}_{1jk}$ sur un premier objet de référence (1) avec un premier axe de rotation (6) fixe,
b) on mesure les coordonnées initiales $F_{2\text{-}o}$ et les coordonnées de calibrage $\vec{r}_{2jk}$ sur un deuxième objet de référence (2) avec un deuxième axe de rotation (7) fixe,
c) on injecte toutes les coordonnées initiales et de calibrage mesurées dans la même fonction de correction $\vec{K}(\vec{r}_{jk})$,
d) on ramène les coordonnées de calibrage $(\vec{r}_{1jk} + \vec{K}(\vec{r}_{jk}))$ et $(\vec{r}_{2jk} + \vec{K}(\vec{r}_{jk}))$, injectées avec la fonction de correction $\vec{K}(\vec{r}_{jk})$ séparément pour chaque objet de référence (1, 2), à leur orientation initiale respective en utilisant les fonctions de rotation $D_k$,
e) et on calcule les paramètres d'ajustement $a_i$ de telle sorte que séparément, sur chaque objet de référence (1) et (2), toutes les coordonnées de calibrage ramenées en arrière et corrigées et les coordonnées initiales correspondent le mieux possible pour chaque structure de référence (5).

**3.** Procédé selon la revendication 1, avec les étapes supplémentaires suivantes ;

a) on détermine en plus des fonctions d'ajustement $\vec{k}_i(\vec{r}_{jk})$ définies, toutes les combinaisons linéaires

$$\vec{S}(\vec{r}) = \sum_{i=0}^{P} s_i \vec{k}_i(\vec{r}_{jk})$$

symétriques par rotation d'un nombre quelconque P < N de fonctions d'ajustement $\vec{k}_i(\vec{r}_{jk})$ avec les paramètres d'ajustement $s_i$ qui satisfont la condition de symétrie $\vec{S}(\vec{r}) = D_k \vec{S}(\vec{r})$ pour les fonctions de rotation $D_k$,
b) on remplace l'ancienne série de fonctions d'ajustement $\vec{k}_i(\vec{r}_{jk})$ linéaires indépendantes par une nouvelle série de fonctions d'ajustement $\vec{k}^{(1)}_i(\vec{r}_{jk})$ linéaires indépendantes lorsqu'il existe une telle combinaison linéaire $\vec{S}(\vec{r})$ symétrique par rotation, ces nouvelles fonctions d'ajustement $\vec{k}^{(1)}_i(\vec{r}_{jk})$ étant respectivement des combinaisons linéaires des anciennes $\vec{k}_i(\vec{r}_{jk})$ et englobent le même domaine de fonctions et une des nouvelles fonctions d'ajustement en l'occurrence $\vec{k}^{(1)}_N(\vec{r})$ étant la combinaison linéaire $\vec{S}(\vec{r})$ symétrique par rotation,
c) on supprime la combinaison linéaire $\vec{S}(\vec{r})$ =

$\vec{k}^{(1)}{}_N(\vec{r}_{jk})$ symétrique par rotation, de la série de fonctions d'ajustement $\vec{k}^{(1)}{}_i(\vec{r}_{jk})$ de telle sorte que leur nombre ne soit plus que N-1,

d) on répète les étapes nommées a), b), c) du procédé jusqu'à ce qu'il n'existe plus de combinaison linéaire $\vec{S}(\vec{r})$ qui satisfasse la condition de symétrie $\vec{S}(\vec{r})=D_k\vec{S}(\vec{r})$ pour les fonctions de rotation $D_k$

e) et on calcule la fonction de correction $\vec{k}(\vec{r}_{jk})$ avec la série de fonctions d'ajustement $\vec{k}^{(M)}{}_i(\vec{r}_{jk})$ obtenue par la répétition M fois des étapes a), b), c) du procédé décrites précédemment.

4. Procédé selon la revendication 3, avec les étapes supplémentaires suivantes :

a) on détermine une première fonction de correction $\vec{K}_1(\vec{r}_{jk})$ avec un premier objet de référence (1) et des rotations $D_{1k}$ autour d'un premier axe de rotation (6) fixe, qui par rapport à toutes les rotations $D_{1k}$ autour du premier axe de rotation (6), ne contient plus aucune combinaison linéaire $\vec{S}(\vec{r})$ symétrique par rotation, mais qui contient toutefois des combinaisons linéaires $\vec{S}(\vec{r})$ symétriques par rotation par rapport à d'autres axes de rotation non utilisés,

b) on réalise d'autres mesures de calibrage avec un deuxième objet de référence (2) et des rotations avec des fonctions de rotation $D_{2k}$ autour d'un deuxième axe de rotation (7) fixe différent du premier permettant de corriger toutes les coordonnées initiales $\vec{r}_{2j0}$ et coordonnées de calibrage $\vec{r}_{2jk}$ mesurées du deuxième objet de référence (2) avec la première fonction de correction $\vec{K}_1(\vec{r}_{jk})$ déjà calculée, qui est alors injectée avec les coordonnées de calibrage corrigées par la première fonction de correction $\vec{K}_1(\vec{r}_{jk})$ dans une deuxième fonction de correction $\vec{K}_2(\vec{r}_{jk})$ restant à définir et qui est ramenée en arrière dans son orientation initiale par les fonctions de rotation $D_{2k}$, et à partir de cela on définit une deuxième fonction de correction $\vec{K}_2(\vec{r}_{jk})$ qui ne contient plus aucune combinaison linéaire $\vec{S}(\vec{r})$ symétrique par rotation par rapport à toutes les rotations $D_{2k}$ autour du deuxième axe de rotation (7), mais qui contient toutefois des combinaisons linéaires $\vec{S}(\vec{r})$ symétriques par rotation par rapport à toutes les rotations $D_{1k}$ autour du premier axe de rotation (6)

c) et en additionnant la première fonction de correction $\vec{K}_1(\vec{r}_{jk})$ à la deuxième fonction de correction $\vec{K}_2(\vec{r}_{jk})$, on calcule une fonction de correction globale contenant des combinaisons linéaires $\vec{S}(\vec{r})$ symétriques par rotation par rapport aux rotations $D_{1k}$ et $D_{2k}$ utilisées autour des deux axes de rotation.

5. Procédé selon la revendication 4, dans lequel on affine la fonction de correction $\vec{K}_{Ges}(\vec{r}_{jk})$ étape après étape en répétant l'étape b) de la revendication 2 avec d'autres objets de référence et leurs autres axes de rotation associés, non utilisés précédemment et on continue toujours à additionner les fonctions de correction obtenues.

6. Procédé selon la revendication 2, 4 ou 5, dans lequel un des objets de référence couvre la totalité de la plage de mesure de la machine de mesure de coordonnées.

7. Procédé selon une des revendications précédentes, dans lequel l'objet de référence est carré et l'axe de rotation traverse son milieu.

$$\vec{K}_{Ges}\left(\vec{r}_{jk}\right) = \vec{K}_1\left(\vec{r}_{jk}\right) + \vec{K}_2\left(\vec{r}_{jk}\right)$$

## Fig.1a

3  6  5

1  4

## Fig.1b

## Fig.1c

EP 0 931 241 B1

EP 0 931 241 B1

*Fig.2c*

*Fig.2b*

*Fig.2a*

14